# EUROPEAN PATENT SPECIFICATION

(11) **EP 4 439 087 B1**
(45) Date of publication and mention of the grant of the patent: **02.12.2026**
(21) Application number: 24163815.4
(22) Date of filing: 15.03.2024
(51) Int. Cl.: G01R 15/18

(54) **INDUCTIVE COUPLING PROXIMITY CURRENT SENSOR FOR ENERGY MEASUREMENT**
STROMSENSOR MIT INDUKTIVER NAHFELDKOPPLUNG ZUR ENERGIEMESSUNG
CAPTEUR DE COURANT DE PROXIMITÉ À COUPLAGE INDUCTIF POUR MESURE D'ÉNERGIE

(30) Priority: 31.03.2023 US 202363456430 P; 12.09.2023 US 202318367233
(43) Date of publication of application: 02.10.2024
(73) Proprietor: Schneider Electric USA, Inc., Andover, MA 01810 (US)
(72) Inventor: RENDON HERNANDEZ, Adrian Abdala, Andover, MA 01810 (US); MELECIO RAMIREZ, Juan Ignacio, Andover, MA 01810 (US); FISCHELS, Collin Richard, Andover, MA 01810 (US); DERBY, Austin, Andover, MA 01810 (US)
(74) Representative: Manitz Finsterwald Patent- und Rechtsanwaltspartnerschaft mbB

(56) References cited:
- CN-A- 101 677 031
- US-A1- 2010 109 643
- US-A1- 2020 388 436
- US-B1- 6 414 475

## Description

### TECHNICAL FIELD

The present disclosure relates to circuit breakers, metering devices, wiring devices, and other devices that monitor and measure current flow, and more particularly to systems and methods for sensing current in such devices using a planar coil current sensor having a reduced size to allow for easier installation.

### BACKGROUND

Modern protection devices (e.g., circuit breakers), metering devices, wiring devices, and other devices that monitor and measure current flow and energy usage have components that enable several functions not previously available in prior devices. For example, a CPU (e.g., microcontroller) in an electronic circuit breaker allows the breaker to function as both a ground fault circuit interrupt (GFCI) device as well as an arc fault circuit interrupt (AFCI) device. The CPU detects such faults by constantly sensing and sampling line current and monitoring these currents.

In many electronic circuit breakers, the current sensor is a current transformer that has a large number of wire loops, or windings, wrapped around a toroidal core, usually ferromagnetic material alloys. The current transformer may be optimized by adjusting the number of windings (turns), by using a ferrite core, and the like. Some circuit breakers use a so-called "coreless" current sensor, also known as a "current rate of change" or "di/dt" sensor, a "current rise time" sensor, or a Rogowski coil, where the toroidal core is non-ferromagnetic. The Rogowski coil type current sensor provides an output signal, which is a voltage, that is proportional to the rate of change of the input signal, which is the line current.

Current transformers are also frequently employed for energy transfer, electrical isolation, and signal transfer. Traditional transformers often include copper windings that are wound on magnetic core. Because ferromagnetic materials, which are used to make the magnetic cores, provide excellent conduction routes for the magnetic flux, the use of magnetic cores in transformers is typically considered to be important.

However, the use of conventional current transformers as current sensors presents several design challenges. For one thing, these current transformers tend to be bulky and occupy a lot of space, making them difficult to incorporate into an already crowded electronic circuit breaker. This is especially true for miniature circuit breakers (MCB) where internal spacing is even more constrained. Additional challenges also arise due to the increased mechanical complexity that typically accompanies installation of such conventional current transformers within a circuit breaker, wiring device, or metering device.

Accordingly, a need exists for a way to reduce the internal spacing required by current sensors within devices that monitor and measure current flow.

US 2020/388436 A1 discloses an air-core inductor assembly including a printed circuit board (PCB) comprising a current sensor, and a portion of a first air-core inductor coil mounted on the printed circuit board. The current sensor is formed integrally with the printed circuit board, and a portion of the first air-core inductor coil is arranged in proximity to the current sensor to provide an electromagnetic coupling in use.

### SUMMARY

The present disclosure provides a current flow monitoring device and a method of providing a current sensor for use in a current flow monitoring device according to the independent claims. Embodiments are given in the subclaims, the description and the drawings.

Embodiments of the present disclosure relate to systems and methods for reducing the internal spacing required by current sensors within protection devices, wiring devices, metering devices, and other devices that monitor and measure current flow and energy usage. In some embodiments, the systems and methods provide a planar coil current sensor in which an electrically conductive trace is formed on a printed circuit board (PCB) substrate in a spiral or winding pattern to form a planar coil. The spiral pattern may take the form of a polygonal, circular, or other shape depending on the particular implementation. Such a planar coil current sensor may then be placed in close proximity to a current carrying conductor to sense the current in the conductor. The current in the conductor induces an electromagnetic field around the conductor that, in turn, generates a voltage in the nearby planar coil current sensor. The inductively coupled voltage in the planar coil current sensor may then be used to monitor and measure the current in the conductor.

In some embodiments, the PCB substrate includes multiple layers, each layer having an electrically conductive trace arranged thereon in a spiral pattern, which may take the form of a polygonal, circular, or other shape, to form a planar coil. In some embodiments, an electromagnetic shield may be fitted to the PCB substrate. In some embodiments, a front end processor and conditioner circuit may be provided on the PCB substrate. In some embodiments, multiple planar coil current sensors may be used, each planar coil current sensor mounted in close proximity to a respective current conductor.

The above planar coil current sensor provides several advantages over current sensors that are based on conventional current transformers. For example, the planar coil current sensor as a reduced volume, small footprint, low profile, simple hardware architecture, installs more easily into current flow monitoring devices (e.g., circuit breakers, metering devices, or wiring devices), and is relatively inexpensive to manufacture compared to current sensors that are based on conventional current transformers.

An additional advantage is the ability to produce the above planar coil current sensor using PCB design and fabrication techniques. PCB technology allows the planar coil current sensor herein to achieve far more precise and accurate specifications automatically compared to conventional current sensors by using a PCB substrate with multiple layers.

In general, in one aspect, embodiments of the present disclosure relate to a current sensor. The current sensor comprises, among other things, a printed circuit board (PCB) substrate, and at least one electrically conductive trace arranged on the PCB substrate in a generally spiral pattern to form a planar coil. The current sensor further comprises at least one vertical interconnect access (via) in the PCB substrate connected to the electrically conductive trace, the at least one via connected to provide a lead terminal for the electrically conductive trace.

In general, in another aspect, embodiments of the present disclosure relate to a current flow monitoring device. The current flow monitoring device comprises a current conductor in the current flow monitoring device, and a neutral conductor in the current flow monitoring device. The current flow monitoring device further comprises a planar coil current sensor mounted in the current flow monitoring device in close proximity to the current conductor, and a monitoring circuit operable to monitor the planar coil current sensor and determine an amount of current flowing through the current conductor. The current flow monitoring device is one of: an advanced function miniature circuit breaker, a ground fault interrupt (GFI) receptacle wiring device, or a GFI smart plug. The planar coil current sensor is positioned to receive an induced alternating electromagnetic field when an alternating current flows through the conductor, such that the induced alternating electromagnetic field intersects the planar coil current sensor at a substantially normal angle.

In general, in still another aspect, embodiments of the present disclosure relate to a method of providing a current sensor for use in a current flow monitoring device. The method comprises, among other things, forming at least one electrically conductive trace on a PCB substrate, the at least one electrically conductive trace arranged in a spiral pattern that resembles a planar coil. The method further comprises providing lead terminals for the at least one electrically conductive trace, the lead terminals connected to the at least one electrically conductive trace using vertical interconnect access (via) in the PCB substrate. The current flow monitoring device is one of: an advanced function miniature circuit breaker, a ground fault interrupt (GFI) receptacle wiring device, or a GFI smart plug. The planar coil current sensor is positioned to receive an induced alternating electromagnetic field when an alternating current flows through the conductor, such that the induced alternating electromagnetic field intersects the planar coil current sensor at a substantially normal angle.

### BRIEF DESCRIPTION OF THE DRAWINGS

FIG. 1 shows a schematic diagram illustrating an exemplary current flow monitoring device that uses a planar coil current sensor according to embodiments of the present disclosure;
FIG. 2 shows a partial perspective view illustrating an exemplary planar coil current sensor installed within a current flow monitoring device according to embodiments of the present disclosure;
FIG. 3 shows a partial perspective view illustrating multiple planar coil current sensors installed within a current flow monitoring device according to embodiments of the present disclosure;
FIGS. 4A-4D show conceptual diagrams illustrating operation of an exemplary planar coil current sensor according to embodiments of the present disclosure;
FIGS. 5A-5C show perspective views illustrating exemplary conductive traces for a planar coil current sensor according to embodiments of the present disclosure;
FIG. 6 show a perspective view of an electromagnetic shield that may be used with the planar coil current sensor according to embodiments of the present disclosure;
FIGS. 7A and 7B show conceptual diagrams illustrating operation of another exemplary planar coil current sensor according to embodiments of the present disclosure;
FIGS. 8A and 8B show conceptual diagrams illustrating operation of yet another exemplary planar coil current sensor according to embodiments of this disclosure;
FIG. 9 shows a graph illustrating exemplary performance of a planar coil current sensor according to embodiments of the present disclosure; and
FIG. 10 shows a flowchart illustrating an exemplary method that may be used with a planar coil current sensor according to embodiments of the present disclosure.

### DETAILED DESCRIPTION

This description and the accompanying drawings illustrate exemplary embodiments of the present disclosure and should not be taken as limiting, with the claims defining the scope of the present disclosure, including equivalents. Various mechanical, compositional, structural, electrical, and operational changes may be made without departing from the scope of this description and the claims, including equivalents. In some instances, well-known structures and techniques have not been shown or described in detail so as not to obscure the disclosure. Further, elements and their associated aspects that are described in detail with reference to one embodiment may, whenever practical, be included in other embodiments in which they are not specifically shown or described. For example, if an element is described in detail with reference to one embodiment and is not described with reference to a second embodiment, the element may nevertheless be claimed as included in the second embodiment.

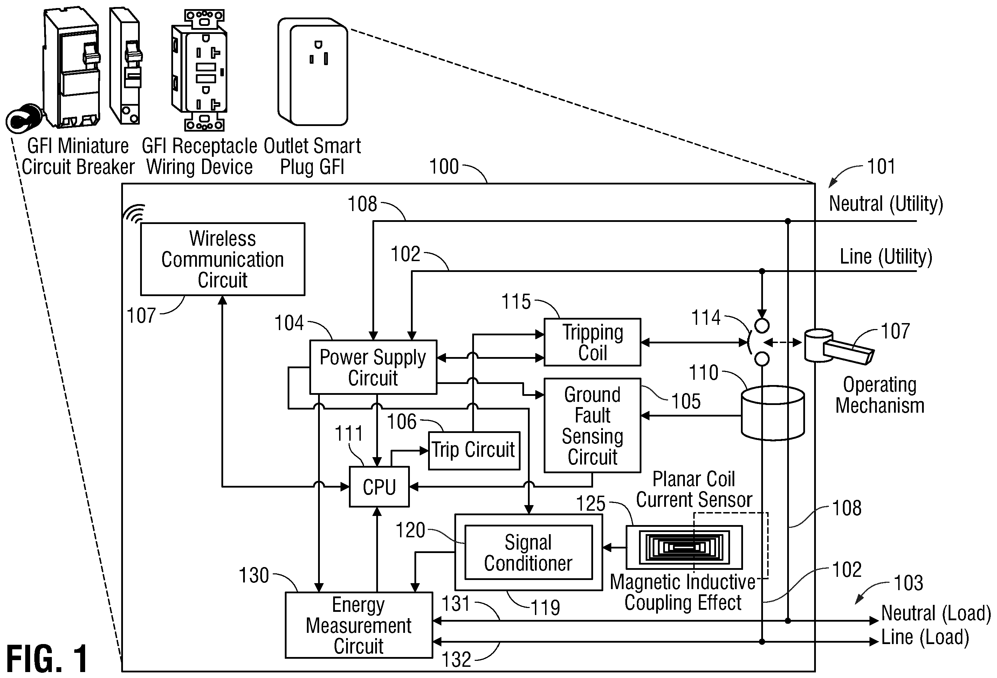

Referring now to FIG. 1, a schematic diagram is shown for an exemplary current flow monitoring device 100 that uses a planar coil current sensor according to embodiments of the present disclosure. The current flow monitoring device 100 in this example is a single-pole electronic circuit breaker 100 that is designed to monitor current flow and interrupt the current flow upon occurrence of a fault condition. To this end, the breaker 100 includes a number of functional components or modules, some of which are represented here as blocks. It will be understood, of course, that each block shown here (and in subsequent figures) may be divided into several constituent blocks, or two or more blocks may be combined into a single block, within the scope of the present disclosure.

As can be seen, the breaker 100 has a utility power line and a utility neutral line connected to the line side 101 of the breaker 100. Current from the utility power line is carried over a main conductor 102 to various loads connected to the load side 103 of the breaker 100. A neutral conductor 108 connects the load neutrals to the utility neutral line. The breaker 100 in this example includes a ground fault sensing circuit 105 connected to a ground fault sensor 110. Current carried by the main conductor 102 is sensed by the ground fault sensor 110 and also by a current sensor 125. An integrator or other signal processing front end 119, which may include a signal conditioner 120, receives current sensor signals from the current sensor 125 and provides the signals to an energy measurement circuit 130. Power for the energy measurement circuit 130, CPU 111, and other components in the breaker 100 is provided by a power supply circuit 104, as shown.

Operation of the breaker 100 is generally well known in the art and therefore only described briefly here. In general, the CPU 111, which may be a microcontroller, monitors current measurements obtained from the ground fault sensor 110 to detect occurrence of a fault condition in a known manner. Upon detection of a fault condition, the CPU 111 outputs a trip signal to a trip circuit 106 that actuates a tripping coil 115, which in turn opens a trip mechanism 114 (e.g., switch, relay) to interrupt current flow through the breaker 100. A reset mechanism 107 allows a user to later set/reset the trip mechanism 114 after a trip event. Energy and power usage is measured by the energy measurement circuit 130 using line voltage 132, neutral voltage 131, and current signal supplied by a signal processing front end 119. A wireless communication circuit 107 may be used to transmit trip data, current measurements, energy measurements, and other information to an external monitoring system, such as a power usage monitoring system, for analysis.

In accordance with embodiments of the present disclosure, the current sensor 125 is a planar coil current sensor in which an electrically conductive trace is formed on a PCB substrate in a spiral winding pattern to form a planar coil. The spiral winding, for purposes of the entire present disclosure, may take any suitable shape that can form a coil, including a polygonal, circular, or other suitable shapes known to those having ordinary skill in the art. Such a planar coil current sensor provides several advantages over conventional current sensors, including a reduced volume, small footprint, low profile, simple hardware architecture, easier assembly and installation, and is relatively inexpensive to manufacture compared to conventional current transformers. As an example, the planar coil current sensor herein was found in one implementation to have about a 2.5X reduction in volume over an equivalent conventional current sensor.

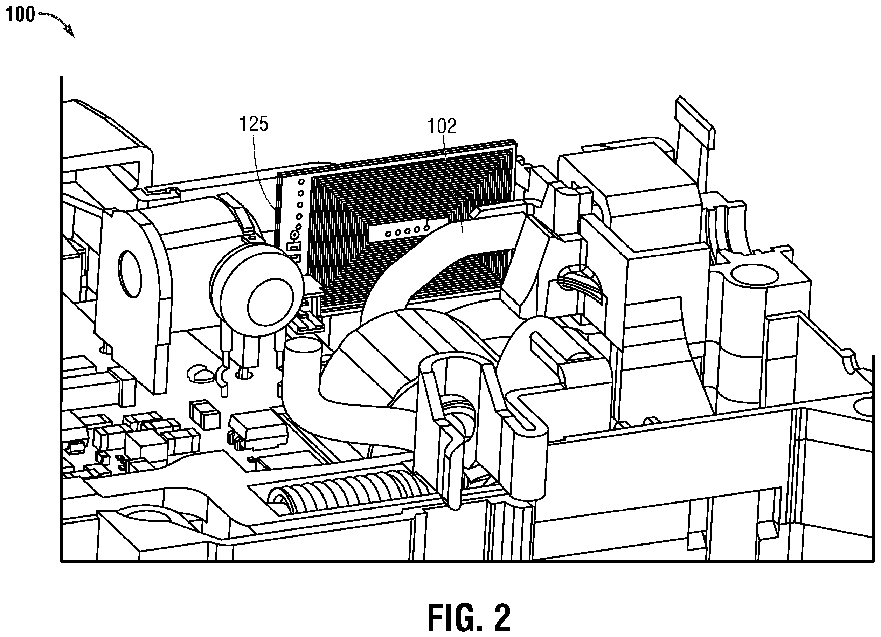

FIG. 2 is a partial perspective view showing the breaker 100 with the planar coil current sensor 125 installed therein according to embodiments of the present disclosure. The current sensor 125 may be secured within the breaker 100 using any suitable technique (e.g., mounting brackets, etc.) known to those having ordinary skill in the art for mounting a PCB in a circuit breaker like the breaker 100. As can be seen, the planar coil current sensor 125 is used in the breaker 100 to sense current in a similar manner as a conventional current sensor, but by running the main conductor 102 in close proximity to the current sensor 125 rather than through the current sensor. Unlike a conventional current sensor, however, installation of the planar coil current sensor 125 is simpler and requires less space in the breaker 100 due to its reduced volume, small footprint, and low profile. As alluded to above, these attributes make the planar coil current sensor 125 especially suitable for use in circuit breakers where internal spacing is highly constrained, such as miniature circuit breakers (MCB).

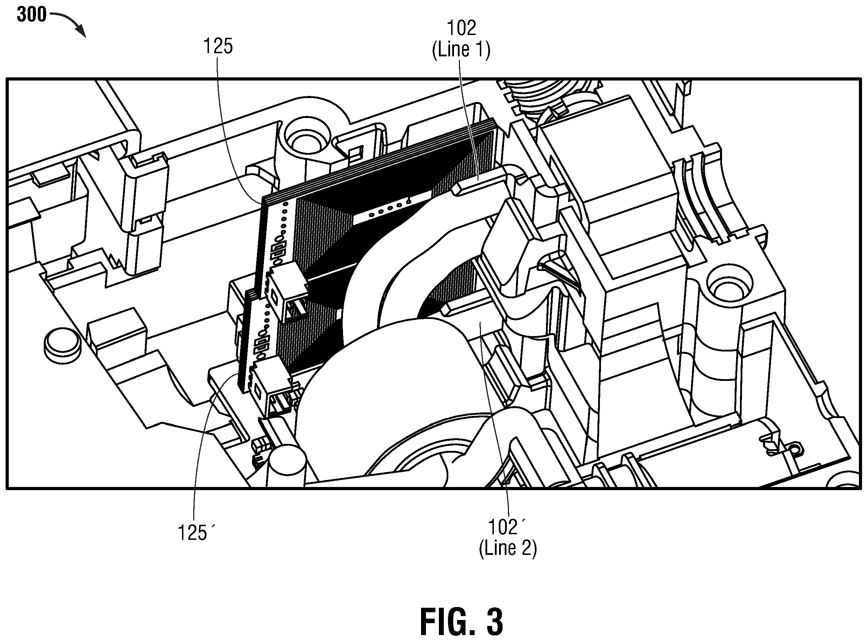

FIG. 3 is a partial perspective view showing another breaker 300 having multiple planar coil current sensors 125, 125' installed therein according to embodiments of the present disclosure. The breaker 300 in this example operates in a similar manner as the breaker 100 from FIG. 2, except that the breaker 300 has two poles and uses two planar coil current sensors, one planar coil current sensor 125 in close proximity to the main conductor 102 (Line 1), and a separate but similar planar coil current sensor 125' in close proximity to a second conductor 102' (Line 2). The breaker 300 may then detect occurrence of a fault condition based on current sensed by the ground fault sensor 110, and monitor and measure energy and power usage using an energy measurement circuit like the energy measurement circuit 130. The energy measurement circuit calculates energy and power using current signals collected by the planar coil current sensors 125 and 125' from Line 1 and Line 2, respectively, and voltages from Line 1 and Line 2, respectively.

Persons having ordinary skill in the art will appreciate that additional planar coil current sensors similar to the planar coil current sensor 125 may also be used, depending on the particular application. In breaker 100, for instance, the main conductor 102 and/or the neutral conductor 108 are sensed by a single planar coil current sensor. Nevertheless, two or more of such planar coil current sensors may be utilized to monitor current in several conductors (e.g., Line 1, Line 2, Line 3, Neutral, etc.).

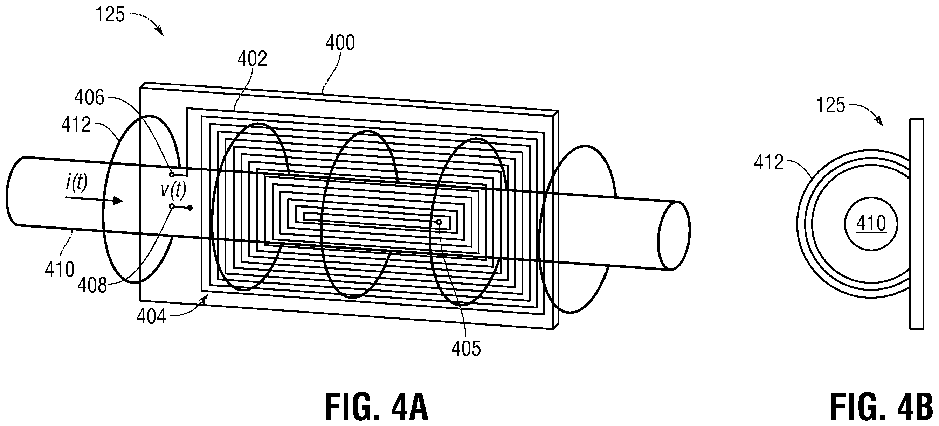

FIGS. 4A and 4B are conceptual diagrams showing front and side views, respectively, of the planar coil current sensor 125 in operation according to embodiments of the present disclosure. As these figures illustrate, the planar coil current sensor 125 is composed of a generally rectangular contour PCB substrate 400 having a conductive trace 402 formed thereon in a spiral or winding pattern that resembles a planar coil, indicated at 404. Lead terminals 406, 408 are provided to allow the planar coil current sensor 125 to be electrically connected to other components within the breaker 100, such as an integrator or other signal processing front end. The lead terminals 406, 408 may take any suitable form, with one of the lead terminals 408 implemented by routing a trace from an interior end 405 of the planar coil 404 internally through the PCB substrate 400 near to or adjacent the other lead terminal 406 by means of vias (not expressly labeled).

In general operation, as understood in the art, an alternating current *i(t)* flowing in a conductor 410 near the planar coil current sensor 125 induces an alternating electromagnetic field around the conductor 410, indicated by field lines 412. The alternating electromagnetic field in turn induces an alternating voltage *v(t)* in the planar coil 404 that is proportional to the current *i(t)* in the conductor 410. The alternating voltage *v(t)* can then be sampled and measured at the terminals 406, 408 to monitor the current flowing through the conductor 410. Note that a portion of the conductor 410 is illustrated in a see-through manner here so as to render the conductive trace 402 behind the conductor 410 visible for ease of understanding.

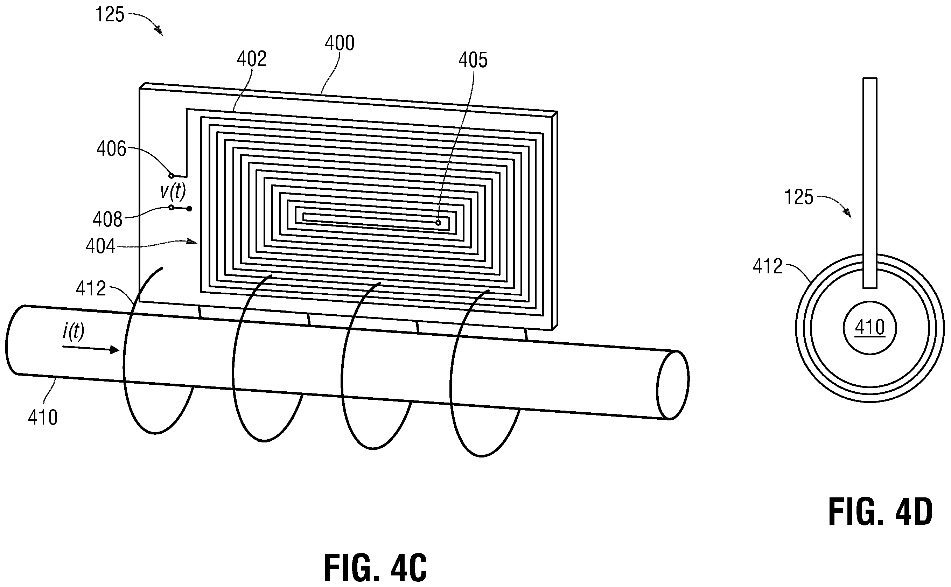

In the example of FIGS. 4A and 4B, which does not fall within the claimed subject-matter, the planar coil current sensor 125 is positioned so that the conductor 410 extends along a face of the planar coil 404 and the induced electromagnetic field lines 412 intersect the planar coil 404 at an oblique angle. Preferably the planar coil current sensor 125 is positioned so that the conductor 410 is centered on the planar coil 404, but this is not a critical requirement. The implementation according to the invention can be seen in FIGS. 4C and 4D, which show front and side views, respectively, of the planar coil current sensor 125 positioned edge-on to the conductor 410. In this arrangement, the induced electromagnetic field lines 412 intersect the planar coil 404 at a substantially normal angle rather than an oblique angle. In either case, the planar coil current sensor 125 is preferably positioned so that the conductor 410 runs substantially parallel to a length (or width) of the planar coil 404, but again, this is not a critical requirement.

In some embodiments, instead of each planar coil current sensor having one planar coil formed thereon, it is possible for the current sensor to have more than one planar coil. For example, the PCB substrate may have multiple layers and a planar coil may be formed on each layer. It is also possible for two or more separate and distinct planar coils to be formed on any given layer of the PCB substrate. In such an embodiment, the two or more planar coils may be arranged next to each other, or they may be interleaved with one another.

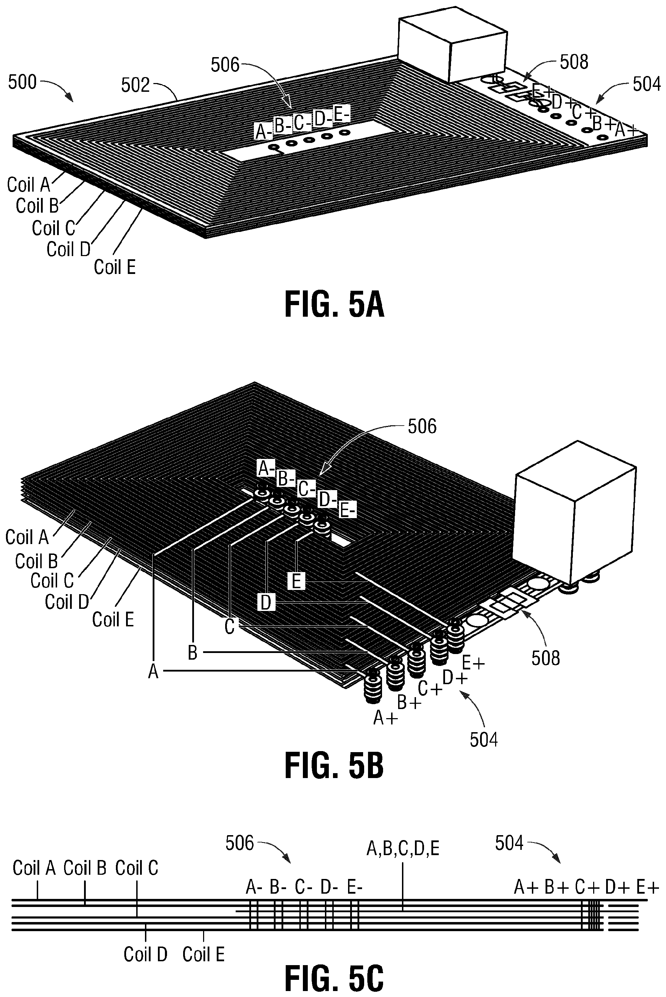

FIGS. 5A-5C are perspective views showing a planar coil current sensor 500 according to embodiments of the present disclosure in which multiple coils are formed on the PCB substrate. Referring first to FIG. 5A, the planar coil current sensor 500 in this example is similar to the planar coil current sensors discussed previously insofar as there is a generally rectangular contour PCB substrate 502 having a planar coil formed on a top layer thereof. However, the PCB substrate 502 here may also have one or more planar coils formed on one or more additional layers in addition to the top layer.

In the example shown, the PCB substrate 502 has five planar coils, Coils A, B, C, D, and E, which are connected internally in series with one another. Each of the coils is electrically distinct from the other coils, as indicated by their respective lead terminals, Terminals A+/A-, B+/B-, C+/C-, D+/D-, and E+/E-. A set of vias 504 may be provided in the PCB substrate 502 to form one set of lead terminals (e.g., Terminals A+, B+, C+, D+, and E+) and a second set of vias 506 may be provided to form the second set of lead terminals (e.g., Terminals A-, B-, C-, D-, and E-). In some embodiments, a signal processor and conditioner, indicated generally at 508, may also be provided on the PCB substrate 502 for convenient front end signal processing and conditioning. Other electrical components may also be provided on the PCB substrate 502 as needed.

FIG. 5B is a partial perspective view showing the conductive traces that form the planar coils on the layers mentioned above, but with the PCB substrate 502 omitted for ease of viewing. As can be seen, there are five traces in this example, each trace arranged in a spiral or winding pattern to form one of the planar coils, Coils A, B, C, D, and E, respectively. Each of the Coils A, B, C, D, and E, is connected to its respective vias 504 and 506 to provide the lead terminals for that coil, Terminals A+/A-, B+/B-, C+/C-, D+/D-, and E+/E-, respectively. Each Coil A, B, C, D, and E is formed from the outside of the PCB substrate (Terminals A+, B+, C+, D+, E+ ) toward the center of the PCB substrate (Terminals A-, B-, C-, D-, E-). In addition, the Coils A, B, C, D, and E are connected in electrical series to one another by interconnecting traces A, B, C, D, and E, respectively. Each interconnecting trace A, B, C, D, and E is used to interconnect a respective coil in one layer to another coil in another layer through their respective vias 504 and 506, while also maintaining the polarity/winding direction of each coil.

FIG. 5C is a partial side view showing the traces that form the various coils discussed above, again, with the PCB substrate 502 omitted for ease of viewing. As this view shows, each of the coils, Coils A, B, C, D, and E, is formed on a different layer from the other coils, and also on a different layer from the interconnecting traces A, B, C, D, and E, which reside on a separate layer from the coils.

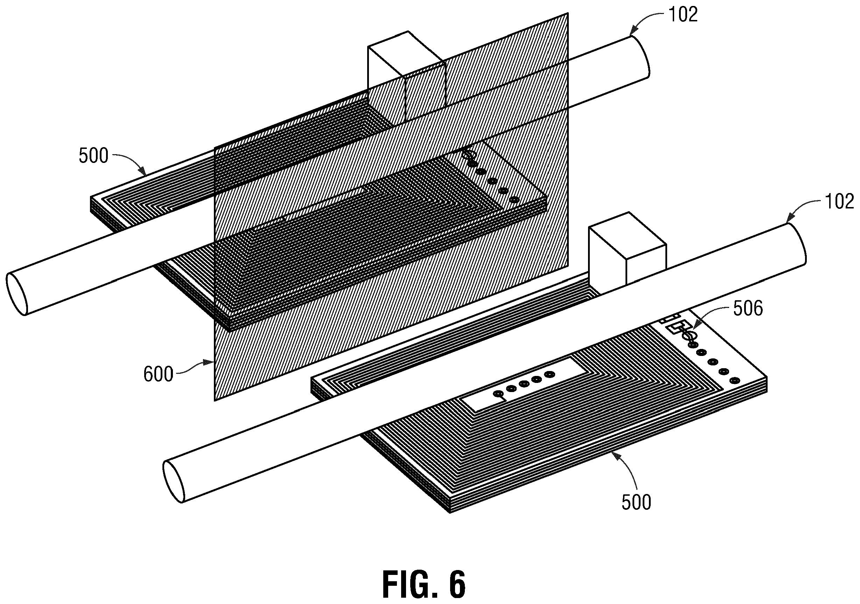

FIG. 6 is a perspective view showing an embodiment in which multiple planar coil current sensors like the planar coil current sensor 500 from FIGS. 5A-5C are used. When multiple planar coil current sensors 500 are mounted in a device like the breaker 300 discussed earlier, crosstalk or other electromagnetic interference may become an issue due to the close proximity of the planar coil current sensors to one another. In such cases, an electromagnetic shield 600 may be positioned between adjacent current sensors 500 to reduce the amount of crosstalk or interference. The shield 600 may be made of a metal or metallic material, and may take the form of a plate in some embodiments, as shown here, or the shield 600 may take the form of an enclosure that fits around or over an individual current sensor 500 to shield the sensor. Other techniques for reducing electromagnetic interference may also be used, such as by modifying the number of turns in a planar coil, changing coil shape and/or orientation, and/or changing the shield shape and/or orientation, and the like.

Thus far, planar coil current sensors have been shown and described wherein the PCB substrates have a generally rectangular contour. Those skilled in the art will appreciate that PCB substrates having non-rectangular contours may also be used within the scope of the present disclosure.

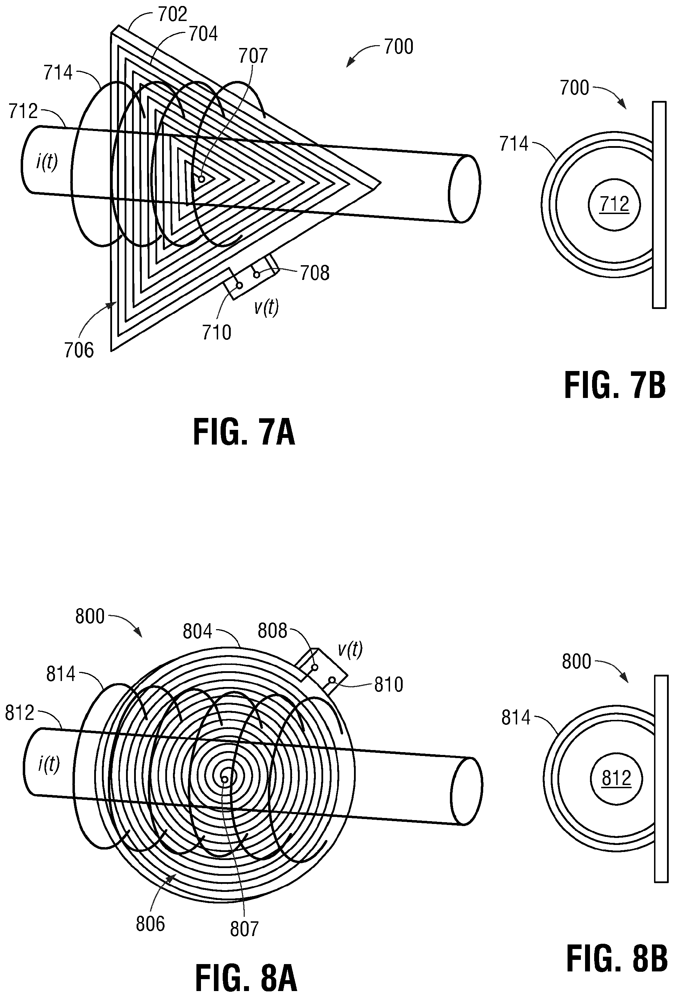

FIGS. 7A and 7B are conceptual diagrams showing front and side views, respectively, of another planar coil current sensor 700, this one having a triangular contour according to some embodiments. As can be seen, the planar coil current sensor 700 is otherwise similar to its rectangular counterpart in FIGS. 4A-4D, except the planar coil current sensor 700 has a generally triangular PCB substrate 702. As before, the PCB substrate 702 has a conductive trace 704 formed thereon in a spiral or winding pattern that resembles a planar coil, indicated at 706. Lead terminals 708, 710 are again provided to allow the planar coil current sensor 700 to be electrically connected to other components within a circuit breaker like the breaker 100. The lead terminals 708, 710 may again take any suitable form, with one of the lead terminals 710 implemented by routing a trace from an interior end 707 of the planar coil 706 internally through the PCB substrate 702 near to or adjacent the other lead terminal 708 by means of vias (not expressly labeled).

In general operation, as described before, an alternating current *i(t)* flowing in a conductor 712 near the planar coil current sensor 700 induces an alternating electromagnetic field around the conductor 712, indicated by field lines 714. The alternating electromagnetic field in turn induces an alternating voltage *v(t)* in the planar coil 706 that is proportional to the current *i(t)* in the conductor 712. The alternating voltage *v(t)* can then be sampled and measured at the terminals 708, 710 to monitor the current flowing through the conductor 712. Note that a portion of the conductor 712 is again illustrated in a see-through manner so as to render the conductive trace 704 behind the conductor 712 visible for ease of comprehension.

FIGS. 8A and 8B are conceptual diagrams showing front and side views, respectively, of yet another planar coil current sensor 800, this one having a circular contour according to some embodiments. As can be seen, the planar coil current sensor 800 is otherwise similar to its rectangular counterpart in FIGS. 4A-4D, except the planar coil current sensor 800 has a generally circular PCB substrate 802. As above, the PCB substrate 802 has a conductive trace 804 formed thereon in a spiral or winding pattern that resembles a planar coil, indicated at 806. Lead terminals 808, 810 are once again provided to allow the planar coil current sensor 800 to be electrically connected to other components within a circuit breaker like the breaker 100. The lead terminals 808, 810 may once again take any suitable form, with one of the lead terminals 810 implemented by routing a trace from an interior end 807 of the planar coil 806 internally through the PCB substrate 802 near to or adjacent the other lead terminal 808 by means of vias (not expressly labeled).

**In** general operation, as described above, an alternating current *i(t)* flowing in a conductor 812 near the planar coil current sensor 800 induces an alternating electromagnetic field around the conductor 812, indicated by field lines 814. The alternating electromagnetic field in turn induces an alternating voltage *v(t)* in the planar coil 806 that is proportional to the current *i(t)* in the conductor 812. The alternating voltage *v(t)* can then be sampled and measured at the terminals 808, 810 to monitor the current flowing through the conductor 812. Note that a portion of the conductor 812 is once again illustrated in a see-through manner so as to render the conductive trace 804 behind the conductor 812 visible.

In the foregoing examples, each of planar coil current sensor 700, 800 is positioned so that the conductor 710, 810 extends along a face of the planar coil 704, 804 and the induced electromagnetic field lines 712, 812 intersect the planar coil 704, 804 at an oblique angle. Although not shown here, in alternative embodiments, the planar coil current sensors 700, 800 may be positioned edge-on to the conductors 710, 810 instead of face-on to the conductors 710, 810. In that case, the induced electromagnetic field lines 712, 812 intersect the planar coil 704, 804 at a substantially normal angle rather than an oblique angle.

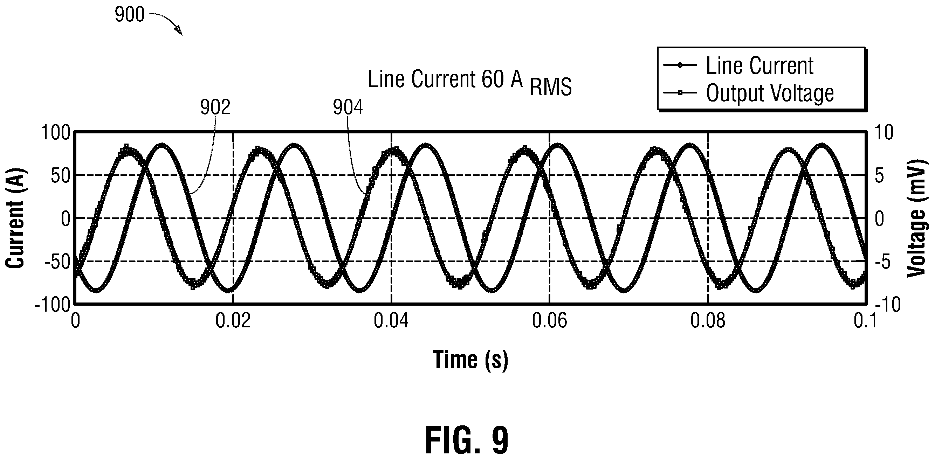

Referring now to FIG. 9, a graph 900 is shown illustrating performance of a planar coil current sensor as described herein under test conditions. In the graph 900, the left vertical axis represents test current, the right vertical axis represents current sensor voltage, and the horizontal axis represents time. Current waveform 902 represents the line current used, 60 Amps RMS, and voltage waveform 904 represents the voltage signal produce by the planar coil current sensor (and conditioned by a signal processing front end) in response to the line current. As can be seen, the voltage waveform 904 closely tracks the current waveform 902, indicating that the planar coil current sensor was able to accurately sense the line current.

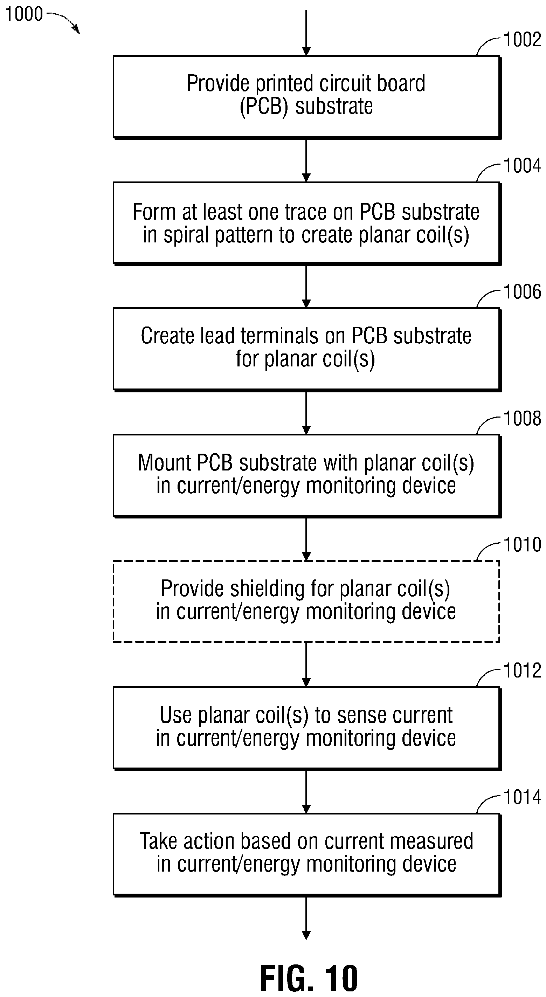

FIG. 10 illustrates a flowchart depicting a method 1000 that may be used with a planar coil current sensor in accordance with embodiments of the present disclosure. The flowchart shows several functional blocks, each block representing a step or function that may be performed in the method 1000. It should be noted that although discrete blocks are shown, those having ordinary skill in the art will appreciate that a given block may be divided into two or more constituent blocks, or two or more of the blocks shown may be combined into a single block, without departing from the scope of the present disclosure. In addition, although the blocks are shown in a particular sequence, those having ordinary skill in the art will understand that a different sequence may be followed without departing from the scope of the present disclosure.

The method 1000 generally begins at block 1002 where a printed circuit board (PCB) substrate is provided. The PCB substrate may have a rectangular contour, or it may have a non-rectangular contour, such as a triangular contour or a circular or oblong contour, depending on the particular implementation. At block 1004, an electrically conductive trace is formed on the PCB substrate in a generally spiral pattern to form a planar coil. The electrically conductive trace may be formed on a top or bottom surface of the PCB substrate, or it may be formed within the PCB substrate on an internal layer of the PCB substrate. In some embodiments, multiple electrically conductive traces may be used to form multiple planar coils. Each coil may occupy a separate layer in the PCB substrate, or two a more coils may occupy the same layer in the PCB substrate in an interleaved fashion.

At block 1006, lead terminals are provided on the PCB substrate for each planar coil, for example, using vias to connect each planar coil to its respective lead terminals. At block 1008, the PCB substrate with the planar coil or coils therein is mounted in a device that monitors current flow and/or energy usage, with each coil positioned adjacent a current conductor in the device. Examples of suitable devices include protection devices (e.g., circuit breakers), metering devices, wiring devices, and similar devices. In some embodiments, multiple such PCB substrates may be mounted in the current flow monitoring device, for example, one PCB substrate for each pole in a multi-pole circuit breaker. At block 1010, optionally, electromagnetic shielding may be provided for the planar coil or coils. The electromagnetic shielding may be in the form of a plate positioned on or near the PCB substrate, or it may be an enclosure that encloses the PCB substrate.

Once the PCB substrate is mounted, at block 1012, the planar coil or coils are used to sense current in the current flow monitoring device in the manner described above. That is, an alternating current flowing in the current conductor induces an alternating electromagnetic field around the conductor, which in turn induces an alternating voltage in the planar coil or coils that is proportional to the current in the conductor. The alternating voltage may then be sampled and used to determine the amount of current flowing in the conductor. At block 1014, appropriate action is taken by the current flow monitoring based on the current measured in the device, such as actuating a trip mechanism in the case of a circuit breaker, or calculating energy usage in the case of a metering device, and the like.

While several embodiments of the present disclosure have been shown and described herein, it is to be understood that the above description is intended to be illustrative, and not restrictive. Many other implementation examples are apparent upon reading and understanding the above description. For example, oval or round (or rounded) shaped planar coils may be used instead of rectangular coils in some embodiments. Thus, although the disclosure describes specific examples, it is recognized that the systems and methods of the disclosure are not limited to the examples described herein, but may be practiced with modifications within the scope of the appended claims. Accordingly, the specification and drawings are to be regarded in an illustrative sense rather than a restrictive sense. The scope of the disclosure should, therefore, be determined with reference to the appended claims.

## Claims

1. A current flow monitoring device (100, 300), comprising:
a current conductor (102, 102', 410, 712, 812) in the current flow monitoring device (100, 300);
a neutral conductor (108) in the current flow monitoring device (100, 300);
a planar coil current sensor (125, 125', 500, 700, 800) mounted in the current flow monitoring device (100, 300) in close proximity to the current conductor (102, 102', 410, 712, 812); and
a monitoring circuit (130) operable to monitor the planar coil current sensor (130) and determine an amount of current flowing through the current conductor (102, 102', 410, 712, 812);
wherein the current flow monitoring device (130) is one of: an advanced function miniature circuit breaker, a ground fault interrupt GFI receptacle wiring device, or a GFI smart plug; and
wherein the planar coil current sensor (125, 125', 500, 700, 800) is positioned to receive an induced alternating electromagnetic field (412, 714, 814) when an alternating current flows through the conductor (102, 102', 410, 712, 812), such that the induced alternating electromagnetic field (412) intersects the planar coil current sensor (125, 125', 500, 700, 800) at a substantially normal angle.

2. The current flow monitoring device (100, 300) according to claim 1, wherein the planar coil current sensor (130) comprises:
a printed circuit board PCB substrate (400, 502, 702, 802);
at least one electrically conductive trace (402, A-E, 704, 804) arranged on the PCB substrate (400, 502, 702, 802) in a spiral pattern to form a planar coil (404, A-E, 706, 806); and
at least one vertical interconnect access (via) (504, 506) in the PCB substrate (400, 502, 702, 802) connected to the electrically conductive trace (402, A-E, 704, 804), the at least one via (504, 506) connected to provide a lead terminal (406, 408, A+-E-, 708, 710 808, 810) for the electrically conductive trace (402, A-E, 704, 804).

3. The current flow monitoring device (100, 300) according to claim 2, wherein the PCB substrate (400, 502, 702, 802) includes multiple layers, each layer having an electrically conductive trace (402, A-E, 704, 804) arranged thereon in a spiral pattern that resembles a planar coil (402, A-E, 704, 804).

4. The current flow monitoring device (100, 300) according to claim 3, wherein each planar coil (404, A-E, 706, 806) on the PCB substrate (400, 502, 702, 802) is connected in electrical series to other planar coils (404, A-E, 706, 806) on the PCB substrate (400, 502, 702, 802).

5. The current flow monitoring device (100, 300) according to claim 2, further comprising an electromagnetic shield (600) positioned on or near to the PCB substrate (400, 502, 702, 802), the electromagnetic shield (600) configured to reduce electromagnetic interference on the planar coil (404, A-E, 706, 806).

6. The current flow monitoring device (100, 300) according to claim 2, further comprising a signal conditioning circuit (120) on the PCB substrate, the signal conditioning circuit (120) configured to provide signal conditioning and processing for any voltage signal outputted by the current sensor (125, 125', 500, 700, 800).

7. The current flow monitoring device (100, 300) according to claim 1, further comprising multiple planar coil current sensors (125, 125', 500, 700, 800), each planar coil current sensor (125, 125', 500, 700, 800) mounted in the current flow monitoring device (100, 300) in close proximity to a respective current conductor (102, 102', 410, 712, 812).

8. A method of providing a current sensor for use in a current flow monitoring device (100, 300), the method comprising:
forming at least one electrically conductive trace (402, A-E, 704, 804) on a PCB substrate (400, 502, 702, 802), the at least one electrically conductive trace (402, A-E, 704, 804) arranged in a spiral pattern that resembles a planar coil (404, A-E, 706, 806); and
providing lead terminals (406, 408, A+-E-, 708, 710 808, 810) for the at least one electrically conductive trace (402, A-E, 704, 804), the lead terminals (406, 408, A+-E-, 708, 710 808, 810) connected to the at least one electrically conductive trace (402, A-E, 704, 804) using vertical interconnect access (via) (504, 506) in the PCB substrate (400, 502, 702, 802);
wherein the current flow monitoring device (100, 300) is one of: an advanced function miniature circuit breaker, a ground fault interrupt GFI receptacle wiring device, or a GFI smart plug; and
wherein the planar coil current sensor (125, 125', 500, 700, 800) is positioned to receive an induced alternating electromagnetic field (412, 714, 814) when an alternating current flows through the conductor (102, 102', 410, 712, 812), such that the induced alternating electromagnetic field (412, 714, 814) intersects the planar coil current sensor (125, 125', 500, 700, 800) at a substantially normal angle.

9. The method according to claim 8, further comprising connecting the lead terminals (504, 506) for the at least one electrically conductive trace (402, A-E, 704, 804) to the current flow monitoring device (100, 300), the at least one electrically conductive trace (402, A-E, 704, 804) being positioned adjacent a current conductor (102, 102', 410, 712, 812) in the current flow monitoring device (100, 300).

10. The method according to claim 8, further comprising providing a signal conditioning circuit (120) on the PCB substrate (400, 502, 702, 802), the signal conditioning circuit (120) operable to provide signal conditioning and processing for any voltage signal outputted by the least one electrically conductive trace (402, A-E, 704, 804).

11. The method according to claim 8, further comprising positioning an electromagnetic shield (600) on or near the PCB substrate (400, 502, 702, 802), the electromagnetic shield (600) configured to reduce electromagnetic interference on the at least one electrically conductive trace (402, A-E, 704, 804).

## Patentansprüche

1. Stromflussüberwachungsvorrichtung (100, 300), umfassend:
einen Stromleiter (102, 102', 410, 712, 812) in der Stromflussüberwachungsvorrichtung (100, 300);
einen Neutralleiter (108) in der Stromflussüberwachungsvorrichtung (100, 300);
einen Stromsensor (125, 125', 500, 700, 800) mit planarer Spule, der in der Stromflussüberwachungsvorrichtung (100, 300) in unmittelbarer Nähe zu dem Stromleiter (102, 102', 410, 712, 812) montiert ist; und
eine Überwachungsschaltung (130), die betreibbar ist, um den Stromsensor (130) mit planarer Spule zu überwachen und eine Strommenge zu bestimmen, die durch den Stromleiter (102, 102', 410, 712, 812) fließt;
wobei die Stromflussüberwachungsvorrichtung (130) eines von: einem Miniatur-Leistungsschalter mit erweiterter Funktion, einer Erdschlussunterbrechungs-GFI-Steckdosenverdrahtungsvorrichtung oder einem GFI-Smart-Stecker ist; und
wobei der Stromsensor so positioniert ist, dass er ein induziertes elektromagnetisches Wechselfeld (412, 714, 814) empfängt, wenn ein Wechselstrom durch den Leiter (102, 102', 410, 712, 812) fließt, so dass das induzierte elektromagnetische Wechselfeld (412) den Stromsensor (125, 125', 500, 700, 800) mit planarer Spule unter einem im Wesentlichen normalen Winkel schneidet.

2. Stromflussüberwachungsvorrichtung (100, 300) nach Anspruch 1, wobei der Stromsensor (130) mit planarer Spule umfasst:
ein Leiterplatten-PCB-Substrat (400, 502, 702, 802);
mindestens eine elektrisch leitfähige Leiterbahn (402, A-E, 704, 804), die auf dem PCB-Substrat (400, 502, 702, 802) in einem spiralförmigen Muster angeordnet ist, um eine planare Spule (404, A-E, 706, 806) zu bilden; und
mindestens einen vertikalen Verbindungszugang (Via) (504, 506) in dem PCB- Substrat (400, 502, 702, 802), der mit der elektrisch leitfähigen Leiterbahn (402, A-E, 704, 804) verbunden ist, wobei das mindestens eine Via (504, 506) verbunden ist, um eine Anschlussklemme (406, 408, A+-E-, 708, 710, 808, 810) für die elektrisch leitfähige Leiterbahn (402, A-E, 704, 804) bereitzustellen.

3. Stromflussüberwachungsvorrichtung (100, 300) nach Anspruch 2, wobei das PCB-Substrat (400, 502, 702, 802) mehrere Schichten umfasst, wobei jede Schicht eine elektrisch leitfähige Leiterbahn (402, A-E, 704, 804) aufweist, die darauf in einem spiralförmigen Muster angeordnet ist, das einer planaren Spule (402, A-E, 704, 804) ähnelt.

4. Stromflussüberwachungsvorrichtung (100, 300) nach Anspruch 3, wobei jede planare Spule (404, A-E, 706, 806) auf dem PCB-Substrat (400, 502, 702, 802) elektrisch in Reihe mit anderen planaren Spulen (404, A-E, 706, 806) auf dem PCB-Substrat (400, 502, 702, 802) verbunden ist.

5. Stromflussüberwachungsvorrichtung (100, 300) nach Anspruch 2, ferner umfassend eine elektromagnetische Abschirmung (600), die auf oder nahe dem PCB-Substrat (400, 502, 702, 802) positioniert ist, wobei die elektromagnetische Abschirmung (600) dazu eingerichtet ist, elektromagnetische Interferenz an der planaren Spule (404, A-E, 706, 806) zu reduzieren.

6. Stromflussüberwachungsvorrichtung (100, 300) nach Anspruch 2, ferner umfassend eine Signalaufbereitungsschaltung (120) auf dem PCB- Substrat, wobei die Signalaufbereitungsschaltung (120) betreibbar ist, um Signalaufbereitung und Signalverarbeitung für jedes von dem Stromsensor (125, 125', 500, 700, 800) ausgegebene Spannungssignal bereitzustellen.

7. Stromflussüberwachungsvorrichtung (100, 300) nach Anspruch 1, ferner umfassend mehrere Stromsensoren (125, 125', 500, 700, 800) mit planarer Spule, wobei jeder Stromsensor (125, 125', 500, 700, 800) mit planarer Spule in der Stromflussüberwachungsvorrichtung (100, 300) in unmittelbarer Nähe zu einem jeweiligen Stromleiter (102, 102', 410, 712, 812) montiert ist.

8. Verfahren zum Bereitstellen eines Stromsensors zur Verwendung in einer Stromflussüberwachungsvorrichtung (100, 300), wobei das Verfahren umfasst:
Ausbilden mindestens einer elektrisch leitfähigen Leiterbahn (402, A-E, 704, 804) auf einem PCB-Substrat (400, 502, 702, 802), wobei die mindestens eine elektrisch leitfähige Leiterbahn (402, A-E, 704, 804) in einem spiralförmigen Muster angeordnet ist, das einer planaren Spule (404, A-E, 706, 806) ähnelt; und
Bereitstellen von Anschlussklemmen (406, 408, A+-E-, 708, 710, 808, 810) für die mindestens eine elektrisch leitfähige Leiterbahn (402, A-E, 704, 804), wobei die Anschlussklemmen (406, 408, A+-E-, 708, 710, 808, 810) mit der mindestens einen elektrisch leitfähigen Leiterbahn (402, A-E, 704, 804) unter Verwendung eines vertikalen Verbindungszugangs (Via) (504, 506) in dem PCB-Substrat (400, 502, 702, 802) verbunden sind;
wobei die Stromflussüberwachungsvorrichtung (100, 300) eines von: einem Miniatur-Leistungsschalter mit erweiterter Funktion, einer Erdschlussunterbrechungs-GFI-Steckdosenverdrahtungsvorrichtung oder einem GFI-Smart-Stecker ist; und
wobei der Stromsensor (125, 125', 500, 700, 800) mit planarer Spule so positioniert ist, dass er ein induziertes elektromagnetisches Wechselfeld (412, 714, 814) empfängt, wenn ein Wechselstrom durch den Leiter (102, 102', 410, 712, 812) fließt, so dass das induzierte elektromagnetische Wechselfeld (412, 714, 814) den Stromsensor (125, 125', 500, 700, 800) mit planarer Spule unter einem im Wesentlichen normalen Winkel schneidet.

9. Verfahren nach Anspruch 8, ferner umfassend das Verbinden der Anschlussklemmen (504, 506) für die mindestens eine elektrisch leitfähige Leiterbahn (402, A-E, 704, 804) mit der Stromflussüberwachungsvorrichtung (100, 300), wobei die mindestens eine elektrisch leitfähige Leiterbahn (402, A-E, 704, 804) neben einem Stromleiter (102, 102', 410, 712, 812) in der Stromflussüberwachungsvorrichtung (100, 300) angeordnet ist.

10. Verfahren nach Anspruch 8, ferner umfassend das Bereitstellen einer Signalaufbereitungsschaltung (120) auf dem PCB-Substrat (400, 502, 702, 802), wobei die Signalaufbereitungsschaltung (120) betreibbar ist, um Signalaufbereitung und Signalverarbeitung für jedes von der mindestens einen elektrisch leitfähigen Leiterbahn (402, A-E, 704, 804) ausgegebene Spannungssignal bereitzustellen.

11. Verfahren nach Anspruch 8, ferner umfassend das Positionieren einer elektromagnetischen Abschirmung (600) auf oder nahe dem PCB-Substrat (400, 502, 702, 802), wobei die elektromagnetische Abschirmung (600) dazu eingerichtet ist, elektromagnetische Interferenz an der mindestens einen elektrisch leitfähigen Leiterbahn (402, A-E, 704, 804) zu reduzieren.

## Revendications

1. Dispositif de surveillance de flux de courant (100, 300), comprenant :
un conducteur de courant (102, 102', 410, 712, 812) dans le dispositif de surveillance de flux de courant (100, 300) ;
un conducteur neutre (108) dans le dispositif de surveillance de flux de courant (100, 300) ;
un capteur de courant à bobine plane (125, 125', 500, 700, 800) monté dans le dispositif de surveillance de flux de courant (100, 300) à proximité immédiate du conducteur de courant (102, 102', 410, 712, 812) ; et
un circuit de surveillance (130) apte à surveiller le capteur de courant à bobine plane (130) et à déterminer une quantité de courant s'écoulant à travers le conducteur de courant (102, 102', 410, 712, 812) ;
dans lequel le dispositif de surveillance de flux de courant (130) est l'un parmi : un coupe-circuit miniature à fonction avancée, un dispositif de câblage de prise GFI à interruption de défaut à la terre, ou une fiche intelligente GFI ; et
dans lequel le capteur de courant à bobine plane (125, 125', 500, 700, 800) est positionné pour recevoir un champ électromagnétique alternatif induit (412, 714, 814) lorsqu'un courant alternatif s'écoule à travers le conducteur (102, 102', 410, 712, 812), de sorte que le champ électromagnétique alternatif induit (412) recoupe le capteur de courant à bobine plane (125, 125', 500, 700, 800) selon un angle sensiblement normal.

2. Dispositif de surveillance de flux de courant (100, 300) selon la revendication 1, dans lequel le capteur de courant à bobine plane (130) comprend :
un substrat de carte de circuit imprimé PCB (400, 502, 702, 802) ;
au moins une piste électriquement conductrice (402, A-E, 704, 804) agencée sur le substrat PCB (400, 502, 702, 802) selon un motif en spirale pour former une bobine plane (404, A-E, 706, 806) ; et
au moins un accès d'interconnexion verticale (via) (504, 506) dans le substrat PCB (400, 502, 702, 802) connecté à la piste électriquement conductrice (402, A-E, 704, 804), ledit au moins un via (504, 506) étant connecté pour fournir une borne de connexion (406, 408, A+-E-, 708, 710 808, 810) pour la piste électriquement conductrice (402, A-E, 704, 804).

3. Dispositif de surveillance de flux de courant (100, 300) selon la revendication 2, dans lequel le substrat PCB (400, 502, 702, 802) comprend plusieurs couches, chaque couche présentant une piste électriquement conductrice (402, A-E, 704, 804) agencée sur celle-ci selon un motif en spirale qui ressemble à une bobine plane (402, A-E, 704, 804).

4. Dispositif de surveillance de flux de courant (100, 300) selon la revendication 3, dans lequel chaque bobine plane (404, A-E, 706, 806) sur le substrat PCB (400, 502, 702, 802) est connectée en série électrique à d'autres bobines planes (404, A-E, 706, 806) sur le substrat PCB (400, 502, 702, 802).

5. Dispositif de surveillance de flux de courant (100, 300) selon la revendication 2, comprenant en outre un blindage électromagnétique (600) positionné sur ou à proximité du substrat PCB (400, 502, 702, 802), le blindage électromagnétique (600) étant configuré pour réduire une interférence électromagnétique sur la bobine plane (404, A-E, 706, 806).

6. Dispositif de surveillance de flux de courant (100, 300) selon la revendication 2, comprenant en outre un circuit de conditionnement de signal (120) sur le substrat PCB, le circuit de conditionnement de signal (120) étant apte à fournir un conditionnement de signal et un traitement du signal pour tout signal de tension délivré par le capteur de courant (125, 125', 500, 700, 800).

7. Dispositif de surveillance de flux de courant (100, 300) selon la revendication 1, comprenant en outre plusieurs capteurs de courant à bobine plane (125, 125', 500, 700, 800), chaque capteur de courant à bobine plane (125, 125', 500, 700, 800) étant monté dans le dispositif de surveillance de flux de courant (100, 300) à proximité immédiate d'un conducteur de courant respectif (102, 102', 410, 712, 812).

8. Procédé de fourniture d'un capteur de courant destiné à être utilisé dans un dispositif de surveillance de flux de courant (100, 300), le procédé comprenant les étapes consistant à :
former au moins une piste électriquement conductrice (402, A-E, 704, 804) sur un substrat PCB (400, 502, 702, 802), ladite au moins une piste électriquement conductrice (402, A-E, 704, 804) étant agencée selon un motif en spirale qui ressemble à une bobine plane (404, A-E, 706, 806) ; et
fournir des bornes de connexion (406, 408, A+-E-, 708, 710 808, 810) pour ladite au moins une piste électriquement conductrice (402, A-E, 704, 804), les bornes de connexion (406, 408, A+-E-, 708, 710 808, 810) étant connectées à ladite au moins une piste électriquement conductrice (402, A-E, 704, 804) en utilisant un accès d'interconnexion verticale (via) (504, 506) dans le substrat PCB (400, 502, 702, 802) ;
dans lequel le dispositif de surveillance de flux de courant (100, 300) est l'un parmi : un coupe-circuit miniature à fonction avancée, un dispositif de câblage de prise GFI à interruption de défaut à la terre, ou une fiche intelligente GFI ; et
dans lequel le capteur de courant à bobine plane (125, 125', 500, 700, 800) est positionné pour recevoir un champ électromagnétique alternatif induit (412, 714, 814) lorsqu'un courant alternatif s'écoule à travers le conducteur (102, 102', 410, 712, 812), de sorte que le champ électromagnétique alternatif induit (412, 714, 814) recoupe le capteur de courant à bobine plane (125, 125', 500, 700, 800) selon un angle sensiblement normal.

9. Procédé selon la revendication 8, comprenant en outre l'étape consistant à connecter les bornes de connexion (504, 506) pour ladite au moins une piste électriquement conductrice (402, A-E, 704, 804) au dispositif de surveillance de flux de courant (100, 300), ladite au moins une piste électriquement conductrice (402, A-E, 704, 804) étant positionnée adjacente à un conducteur de courant (102, 102', 410, 712, 812) dans le dispositif de surveillance de flux de courant (100, 300).

10. Procédé selon la revendication 8, comprenant en outre l'étape consistant à fournir un circuit de conditionnement de signal (120) sur le substrat PCB (400, 502, 702, 802), le circuit de conditionnement de signal (120) étant apte à fournir un conditionnement de signal et un traitement du signal pour tout signal de tension délivré par ladite au moins une piste électriquement conductrice (402, A-E, 704, 804).

11. Procédé selon la revendication 8, comprenant en outre l'étape consistant à positionner un blindage électromagnétique (600) sur ou à proximité du substrat PCB (400, 502, 702, 802), le blindage électromagnétique (600) étant configuré pour réduire une interférence électromagnétique sur ladite au moins une piste électriquement conductrice (402, A-E, 704, 804).
